# EUROPÄISCHE PATENTSCHRIFT

(11) **EP 1 287 612 B1**
(45) Veröffentlichungstag und Bekanntmachung des Hinweises auf die Patenterteilung: **06.12.2006**
(21) Anmeldenummer: 01933858.1
(22) Anmeldetag: 19.04.2001
(51) Int. Cl.: H03F 1/32

(54) **VORRICHTUNG UND VERFAHREN ZUR VORBEHANDLUNG EINES UNTER VERWENDUNG EINES NICHTLINEAREN VERSTÄRKERS MIT VORGESCHALTETEM BANDPASSFILTER ZU ÜBERTRAGENDEN SIGNALS**
DEVICE AND METHOD FOR PRE-TREATING A SIGNAL TO BE TRANSMITTED USING A NON-LINEAR AMPLIFIER WITH AN UPSTREAM BAND-PASS FILTER
DISPOSITIF ET PROCEDE DE PRETRAITEMENT D'UN SIGNAL A TRANSMETTRE A L'AIDE D'UN AMPLIFICATEUR NON LINEAIRE DOTE D'UN FILTRE PASSE-BANDE AMONT

(30) Priorität: 28.04.2000 DE 10020930
(43) Veröffentlichungstag der Anmeldung: 05.03.2003
(73) Patentinhaber: Fraunhofer-Gesellschaft zur Förderung der angewandten Forschung e.V., 80686 München (DE)
(72) Erfinder: GERHÄUSER, Heinz, 91344 Waischenfeld (DE); PERTHOLD, Rainer, 91085 Weisendorf (DE)
(74) Vertreter: Schoppe, Fritz
(86) Internationale Anmeldenummer: PCT/EP2001/004477
(87) Internationale Veröffentlichungsnummer: WO 2001/084703

(56) Entgegenhaltungen:
- EP-A- 0 885 482
- US-A- 5 049 832
- US-A- 6 072 364

## Beschreibung

Die vorliegende Erfindung bezieht sich auf eine Vorrichtung und ein Verfahren zur Vorbehandlung eines unter Verwendung eines nichtlinearen Verstärkers zu übertragenden Signals, das einer Vorlinearisierung bzw. Vorverzerrung unterworfen wird, um durch den nichtlinearen Verstärker eingeführten Nichtlinearitäten entgegenzuwirken. Insbesondere bezieht sich die vorliegende Erfindung auf eine Vorrichtung und ein Verfahren zur Vorbehandlung eines Signals, das über einen nichtlinearen Verstärker übertragen werden soll, dem ein schmalbandiges Bandpaßfilter vorgeschaltet ist, dessen Durchlaßbandbreite wenig größer als die zu verarbeitende Signalbandbreite ist.

Es ist bekannt, Signale, die unter Verwendung eines nichtlinearen Verstärkers übertragen werden sollen, beispielsweise unter Verwendung eines nichtlinearen Verstärkers, der in einem Kommunikationssatelliten angeordnet ist, einer Vorverzerrung bzw. Vorlinearisierung zu unterziehen, um den durch den Verstärker erzeugten Nichtlinearitäten entgegenzuwirken, bzw. dieselben im Optimalfall vollständig zu kompensieren. Im Fall eines Satellitenübertragungssystems wird auf diese Weise versucht, Verzerrungen, die im Ausgangsverstärker des Satelliten entstehen, durch eine entsprechende Vorverzerrung des Sendesignals in der Bodenstation zu kompensieren.

Ein beispielhaftes Verfahren zum Erzeugen eines linearisierten Verstärkerausgangssignals, in dem durch einen nichtlinearen Verstärker erzeugte Verzerrungen reduziert bzw. kompensiert sind, ansprechend auf ein vorverzerrtes Eingangssignal ist in der US 5,049,832 beschrieben. Bei diesem Verfahren wird das Betragsquadrat des Eingangssignals erfaßt, wobei abhängig von dem Betragsquadrat auf eine Tabelle zugegriffen wird, um das Eingangssignal mit einem vorbestimmten komplexen Koeffizienten zu multiplizieren, um eine Vorverzerrung des Eingangssignals zu bewirken, derart, daß das von dem nichtlinearen Verstärker verstärkte Ausgangssignal nach Betrag und Phase linearisiert ist. Eine Einrichtung zum Vergleichen von Eingangssignal und Ausgangssignal ist vorgesehen, um eine Anpassung der in der Tabelle gespeicherten Koeffizienten vorzunehmen.

Ein alternatives Verfahren zum Durchführen einer Vorverzerrung für eine nichtlineare Übertragungsstrecke im Hochfrequenzbereich ist aus der EP 0885482 B1 bekannt, wobei bei dem dort beschriebenen Verfahren eine Hüllkurve eines Eingangssignals erfaßt und quantisiert wird, um quantisierte Hüllkurvenwerte zu erzeugen. Auf der Grundlage erfaßter, quantisierter Hüllkurvenwerte wird auf eine Tabelleneinrichtung, in der komplexe Vorverzerrungskoeffizienten gespeichert sind, zugegriffen. Das Eingangssignal wird auf der Grundlage der Vorverzerrungskoeffizienten vorverzerrt, derart, daß die durch die nichtlineare Übertragungsstrecke eingeführte Verzerrung nach Betrag und Phase im wesentlichen kompensiert wird.

Noch ein weiteres Verfahren zur Durchführen einer Vorverzerrung bzw. Vorlinearisierung eines über eine nichtlineare Übertragungsstrecke zu übertragenden Übertragungssignals ist in der nicht-vorveröffentlichten deutschen Patentanmeldung 19927952.7 offenbart. Bei dem dort gezeigten Verfahren wird unter Verwendung einer Tabelle, in der komplexe Koeffizienten gespeichert sind, zunächst abhängig von einem Eingangssignal ein Schätzsignal erzeugt, das eine Abschätzung eines durch einen nichtlinearen Verstärker verstärkten Ausgangssignals darstellt. Aus dem Schätzsignal und dem Eingangssignal wird eine Differenz gebildet, die ein Fehlersignal darstellt, das eine Abschätzung des durch den nichtlinearen Verstärker eingeführten Fehlers darstellt. Dieses Fehlersignal wird durch ein zeitdispersives Element zeitlich aufgeweitet und nachfolgend von dem Eingangssignal subtrahiert, um eine Vorlinearisierung des Eingangssignals durchzuführen, derart, daß ein Fehlersignalanteil in dem Frequenzspektrum des Ausgangssignals von dem Nutzfrequenzbereich des Signals weg verschoben wird.

Die oben genannten Vorverzerrungs- bzw. Vorlinearisierungs-Verfahren sowie alle weiteren einer Vielzahl von im Stand der Technik bekannten Vorverzerrungsverfahren, bei denen eine Vorverzerrung bzw. Vorlinearisierung eines Signals vor der Übertragung desselben durch einen nichtlinearen Verstärker vorgenommen wird, scheitern dann, wenn die Bandbreite eines dem nichtlinearen Verstärker vorgeschalteten Kanalfilters im wesentlichen im Bereich der zu verarbeitenden Signalbandbreite ist, bzw. weniger als drei- bis fünfmal die Bandbreite des unverzerrten Signals beträgt.

Die Aufgabe der vorliegenden Erfindung besteht darin, eine Vorrichtung und ein Verfahren zur Vorbehandlung eines unter Verwendung eines nichtlinearen Verstärkers zu übertragenden Signals zu schaffen, die eine ausreichende Vorlinearisierung bzw. Vorverzerrung des zu übertragenden Signals vor dessen Übertragung auch dann ermöglichen, wenn dem nichtlinearen Verstärker ein schmalbandiges Bandpaßfilter vorgeschaltet ist.

Diese Aufgabe wird durch eine Vorrichtung gemäß Anspruch 1 und ein Verfahren gemäß Anspruch 5 gelöst.

Die vorliegende Erfindung schafft eine Vorrichtung zur Vorbehandlung eines über einen Übertragungsweg zu übertragenen Signals, wobei der Übertragungsweg ein Bandpaßfilter, dessen Durchlaßbandbreite kleiner als eine vorbestimmte Bandbreite ist, und einen nichtlinearen Verstärker aufweist, mit folgenden Merkmalen:
einer Linearisierungseinrichtung zum Durchführen einer solchen Linearisierung des zu übertragenden Signals vor der Übertragung, daß einer durch den nichtlinearen Verstärker bewirkten Nichtlinearität entgegenwirkt wird;
einer der Linearisierungseinrichtung nachgeschalteten Signalformungseinrichtung, die einen solchen Frequenzgang aufweist, das der Gesamtfrequenzgang der Signalformungseinrichtung und des Bandpaßfilters dem Frequenzgang eines Filters entspricht, dessen Durchlaßbandbreite zumindest gleich der vorbestimmten Bandbreite ist.

Die vorliegende Erfindung schafft ferner ein Verfahren zum Übertragen eines ersten Signals über einen Übertragungsweg, der ein Bandpaßfilter, dessen Durchlaßbandbreite kleiner als eine vorbestimmte Bandbreite ist, und einen nichtlinearen Verstärker aufweist, mit folgenden Schritten:
Durchführen einer solchen Linearisierung eines ersten Signals, daß eine durch den nichtlinearen Verstärker bewirkte Nichtlinearität kompensiert wird, zum Erzeugen eines Signals;
Leiten des zweiten Signals durch eine Signalformungseinrichtung, die einen solchen Frequenzgang aufweist, daß der Gesamtfrequenzgang der Signalformungseinrichtung und des Bandpaßfilters dem Frequenzgang eines Filters entspricht, dessen Durchlaßbandbreite zumindest gleich der vorbestimmten Bandbreite ist, zum Erzeugen eines dritten Signals;
Übertragen des dritten Signals über den Übertragungsweg.

Die vorliegende Erfindung basiert zunächst auf der Erkenntnis, daß bei sämtlichen bekannten Verfahren zur Vorverzerrung bzw. Vorlinearisierung von über nichtlineare Übertragungsstrecken zu übertragenden Signalen durch die Vorverzerrung bzw. Vorlinearisierung Energie außerhalb des Nutzbandes zu den zu übertragenden Signalen hinzugefügt wird. Diese Energie wird jedoch durch schmalbandige Bandpaßfilter, die dem nichtlinearen Verstärker vorgeschaltet sind, gefiltert bzw. stark reduziert, so daß die Vorverzerrung bzw. Vorlinearisierung nicht den gewünschten Effekt dahingehend, die durch den nichtlinearen Verstärker eingeführte Nichtlinearität zu reduzieren, bzw. im Optimalfall zu kompensieren, hervorrufen kann. Um zu ermöglichen, daß diese Energie außerhalb des Nutzbandes im wesentlichen vollständig zu dem nichtlinearen Verstärker gelangt, um dadurch eine bestimmungsgemäße Linearisierung des Ausgangssignals desselben bewirken zu können, ist erfindungsgemäß eine Signalformungseinrichtung vorgesehen. Die Signalformungseinrichtung weist einen solchen Frequenzgang auf, daß der Gesamtfrequenzgang einer seriellen Zusammenschaltung von Signalformungseinrichtung und dem Bandpaßfilter, das dem nichtlinearen Verstärker nachgeschaltet ist, eine solche Durchlaßbandbreite besitzt, daß neben den Signalanteilen im Nutzband auch die für eine Linearisierung notwendigen, durch die Vorverzerrung bzw. Vorlinearisierung hinzugefügten Energieanteile außerhalb des Nutzbandes ohne übermäßige Dämpfung zu dem nichtlinearen Verstärker gelangen können.

Wird davon ausgegangen, daß durch die Vorverzerrung bzw. Vorlinearisierung Energieanteile innerhalb eines Frequenzbandes eingebracht werden, daß näherungsweise dreimal so breit wie die Nutzbandbreite des zu übertragenden Signals ist, wird der Frequenzgang der Signalformungseinrichtung vorzugsweise derart gewählt, daß der Gesamtfrequenzgang der Signalformungseinrichtung und des Bandpaßfilters dem Frequenzgang eines Filters entspricht, dessen Durchlaßbandbreite zumindest dreimal so groß wie die Signalbandbreite ist. Vorzugsweise wird der Frequenzgang der Signalformungseinrichtung derart eingestellt, daß der Gesamtfrequenzgang einer zusammenschaltung von Signalformungseinrichtung und Bandpaßfilter dem Frequenzgang eines Bandpaßfilters entspricht, dessen Durchlaßbandbreite dreimal bis fünfmal der Signalbandbreite entspricht.

Die Erfindung kann vorzugsweise im Bereich der Satellitenkommunikation angewendet werden, sofern auf dem Satelliten herkömmliche "transparente" Transponder verwendet sind, deren Ausgangsverstärker nichtlineare Verzerrungen verursachen, und die mit einem schmalbandigen, dem Ausgangsverstärker vorgeschalteten Bandpaßfilter ausgerüstet, dessen Bandbreite wenig größer als die zu verarbeitende Signalbandbreite ist. Die Verstärker in derartigen Kommunikationstranspondern sind in der Regel Wanderfeldröhren, die erhebliche Verzerrungen verursachen.

Die Erfindung ermöglicht es, durch den Einsatz herkömmlicher Linearisierungsverfahren, den Ausgangsverstärker eines Satelliten zu linearisieren, selbst wenn das Kanalfilter, das diesem vorgeschaltet ist, eine Linearisierung nach herkömmlichen Methoden nicht gestatten würde. Dies wird erreicht, indem in der Bodenstation die erfindungsgemäße Signalformungseinrichtung einer herkömmlichen Linearisierungseinrichtung nachgeschaltet wird. Dadurch wird eine erhebliche Reduzierung der Nebenaussendungen durch den Ausgangsverstärker des Satelliten erreicht, was wiederum eine höhere Aussteuerung und damit mehr Sendeleistung des Satelliten ermöglicht.

Bevorzugte Ausführungsbeispiele der vorliegenden Erfindung werden nachfolgend bezugnehmend auf die beiliegenden Zeichnungen näher erläutert. Es zeigen:
- Fig. 1: eine grobe, schematische Darstellung eines Satellitenübertragungssystems, bei dem ein Ausführungsbeispiel der vorliegenden Erfindung implementiert ist;
- Fig. 2: ein schematisches Diagramm, das Frequenzgänge zur Erläuterung der vorliegenden Erfindung zeigt.

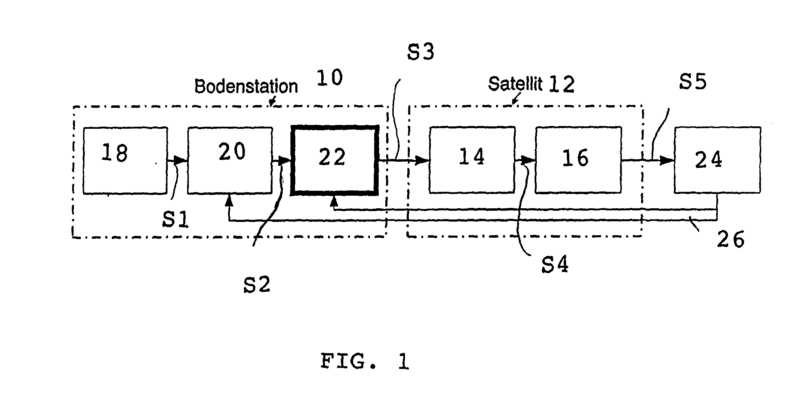

Bezugnehmend auf Fig. 1 wird nachfolgend ein Ausführungsbeispiel der vorliegenden Erfindung erläutert, bei dem dieselbe auf ein Satellitenübertragungssystem angewendet ist.

In Fig. 1 ist schematisch eine Bodenstation 10 und ein Kommunikationssatellit 12 eines Satellitenübertragungssystem dargestellt. Die erfindungsgemäße Vorrichtung zur Vorbehandlung eines über einen Übertragungsweg zu übertragenen Signals ist dabei in der Bodenstation 10 des Satellitenübertragungssystems implementiert.

Existierende Kommunikationssatelliten 12, sogenannte "transparente" Transponder, besitzen in der Regel ein Kanalbandpaßfilter 14, das einem nichtlinearen Verstärker 16 vorgeschaltet ist. Die Bandbreite des Kanalbandpaßfilters 14 ist in der Regel wenig größer als die Signalbandbreite eines zu übertragenden Signals vor einer Vorverzerrung bzw. einer Vorlinearisierung desselben. Der Verstärker 16 des Transponders bzw. Kommunikationssatelliten 12 ist in der Regel eine Wanderfeldröhre, die erhebliche Verzerrungen verursacht.

Die Bodenstation 10 umfaßt eine Signalquelle 18, die ein zu übertragendes Signal S1 erzeugt. An dieser Stelle sei darauf hingewiesen, daß bei bestehenden Systemen die Durchlaßbandbreite des Kanalbandpaßfilters 14 in dem Kommunikationssatelliten 12 an die Signalbandbreite des Eingangssignals S1 angepaßt ist, bzw. wenig größer als dieselbe ist.

Mit dem Ausgang der Signalquelle 18 ist eine Linearisierungseinrichtung 20 verbunden. Die Linearisierungseinrichtung 20 kann eine herkömmliche Linearisierungs- bzw. Vorverzerrungseinrichtung sein, wie sie oben bezugnehmend auf den Stand der Technik beschrieben wurden. Die Linearisierungseinrichtung 20 erzeugt aus dem Eingangssignal S1 ein vorverzerrtes Eingangssignal S2. Der Ausgang der Linearisierungseinrichtung 20 ist erfindungsgemäß mit einer Signalformungseinrichtung 22 verbunden, die zusammen mit dem Kanalbandpaßfilter 14 in dem Kommunikationssatelliten 12 einen Gesamtfrequenzgang erzeugt, der eine Bandbreite aufweist, die wenigstens dreimal so groß wie die Signalbandbreite des Eingangssignals S1 ist. Das Ausgangssignal S3 der Signalformungseinrichtung 22 wird dann zu dem Kommunikationssatelliten 12 übertragen, durch das Kanalbandpaßfilter 14 gefiltert und als gefiltertes Signal S4 dem Ausgangsverstärker des Satelliten 12 zugeführt.

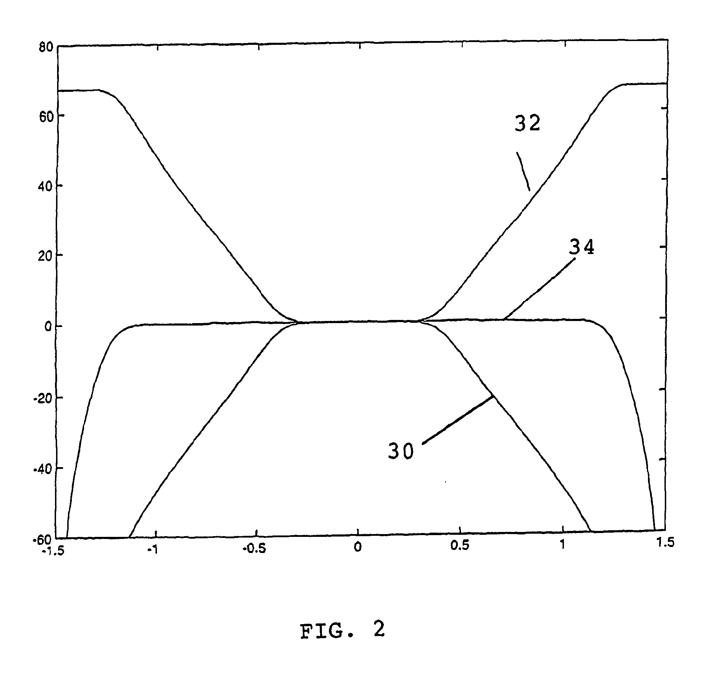

Da der Gesamtfrequenzgang der Kombination aus Signalformungseinrichtung 22 und Kanalbandpaßfilter 14 eine Bandbreite aufweist, die wenigstens dreimal so groß wie die Signalbandbreite ist, wird durch diesen Gesamtfrequenzgang Energie, die durch die Vorverzerrung außerhalb des Nutzbandes hinzugefügt wird, nicht stärker gedämpft als im Nutzband vorliegende Signalanteile. Hinsichtlich des Frequenzgangs der Signalformungseinrichtung 22 und des Kanalbandpaßfilters 14 sowie hinsichtlich des Gesamtfrequenzgangs einer Zusammenschaltung dieser Elemente wird auf die nachfolgende Beschreibung der Fig. 2 verwiesen.

Ein optionaler Testempfänger 24, der in der Bodenstation 10 oder separat von derselben vorgesehen sein kann, empfängt das Ausgangssignal S5 des Kommunikationssatelliten 12 und ermöglicht es somit, über einen Vergleich des Eingangssignals S1 mit dem Ausgangssignal S5 die Charakteristik der Linearisierungseinrichtung 20 und der Signalformungseinrichtung 22 optimal einzustellen, wie in Fig. 1 schematisch durch Pfeile 26 gezeigt ist. Spezieller ausgedrückt werden dadurch beispielsweise Vorverzerrungskoeffizienten der Linearisierungseinrichtung und Koeffizienten der Signalformungseinrichtung, um den gewünschten Frequenzgang zu erzeugen, eingestellt bzw. adaptiert.

In Fig. 2 ist ein Diagramm des Frequenzgangs 30 des Kanalbandpaßfilters 14, des Frequenzgangs 32 der Signalformungseinrichtung 22 und des Gesamtfrequenzgangs 34, der sich bei einer Hintereinanderschaltung der Signalformungseinrichtung 22 und des Kanalbandpaßfilters 30 ergibt, gezeigt.

Auf der Abszisse von Fig. 2 ist die normierte Frequenz ausgehend von einer Mittenfrequenz 0 der Signalbandbreite aufgezeichnet. Auf der Ordinate von Fig. 2 sind normierte Dämpfungs- bzw. Verstärkungs-Werte aufgetragen, wobei klar ist, daß die jeweiligen tatsächlich vorliegenden Frequenz-, Dämpfungs- und Verstärkungs-Werte von dem verwendeten Frequenzband sowie den verwendeten Bauelementen abhängen.

Bezüglich Fig. 2 sei angenommen, daß die Durchlaßbandbreite eines Frequenzgangs 30 des Kanalbandpaßfilters 14 der Signalbandbreite des Eingangssignal entspricht, bzw. nur wenig größer als dieselbe ist. Aufgrund einer derart geringen Bandbreite des Kanalbandpaßfilters 14 würden durch die Linearisierungseinrichtung 20 erzeugte Energieanteile außerhalb des Nutzbandes herausgefiltert werden, so daß die bestimmungsgemäße Linearisierung nicht realisiert werden kann. Daher ist erfindungsgemäß die Signalformungseinrichtung 22 vorgesehen, die einen Frequenzgang 32 aufweist, der im wesentlichen "invers" bzw. "komplementär" zu dem Frequenzgang 30 ist, derart, daß eine Kombination der beiden Frequenzgänge, d.h. eine Addition derselben, die durch eine Hintereinanderschaltung der Elemente 22 und 14 bewirkt wird, einen Gesamtfrequenzgang 34 mit einer Durchlaßbandbreite von wenigstens dreimal der Signalbandbreite erzeugt. Die Signalformungseinrichtung 22 kann somit auch als inverses Bandpaßfilter bezeichnet werden.

Um den in Fig. 2 gezeigten Frequenzgang 32 zu erzeugen, kann die Signalformungseinrichtung 22 aus einer geeigneten Verstärkerschaltung bestehen, die in den Frequenzbereichen, in denen das Kanalbandpaßfilter 14 eine Dämpfung liefert, eine zu der Dämpfung komplementäre Verstärkung besitzt. Somit wird der Gesamtfrequenzgang 34, wie er in Fig. 2 gezeigt ist, erzeugt, der eine Durchlaßbandbreite aufweist, bei der die durch die Vorverzerrung hinzugefügte Energie außerhalb des Nutzbandes im wesentlichen ungedämpft bleibt, bzw. nicht stärker gedämpft wird als das Signal innerhalb des Nutzbandes.

Die vorliegende Erfindung ermöglicht somit den Einsatz bekannter Linearisierungsverfahren auch im Bereich der Satellitenkommunikation unter Verwendung existierender Satelliten, bei denen dem Ausgangsverstärker ein schmalbandiges Bandpaßfilter vorgeschaltet ist.

Abschließend sei darauf hingewiesen, daß die Durchlaßbandbreite des Gesamtfrequenzgangs, der durch die Signalfomungseinrichtung und den Kanalbandpaß erzeugt wird, davon abhängt, in welchen Frequenzbereichen die Vorlinearisierungseinrichtung Energieanteile erzeugt, die benötigt werden, um ein ausreichend linearisiertes Signal am Ausgang des Verstärkers zu erzeugen. In der Regel wird es bei herkömmlichen Vorverzerrungsverfahren ausreichen, die Durchlaßbandbreite des Gesamtfrequenzbandes auf die dreifache bis fünffache Signalbandbreite einzustellen. Abhängig von der verwendeten Vorverzerrung kann jedoch auch eine weniger breite Durchlaßbandbreite des Gesamtfrequenzgangs ausreichen, bzw. kann eine breitere Gesamtdurchlaßbandbreite benötigt werden.

## Patentansprüche

1. Vorrichtung zur Vorbehandlung eines über einen Übertragungsweg zu übertragenden Signals (S1), wobei der Übertragungsweg ein Bandpaßfilter (14), dessen Durchlaßbandbreite (30) kleiner als eine vorbestimmte Bandbreite ist, und einen nichtlinearen Verstärker (16) aufweist, mit folgenden Merkmalen:
einer Linearisierungseinrichtung (20) zum Durchführen einer solchen Linearisierung des zu übertragenden Signals (S1) vor der Übertragung desselben, daß einer durch den nichtlinearen Verstärker (16) bewirkten Nichtlinearität entgegengewirkt wird;
einer der Linearisierungseinrichtung (20) nachgeschalteten Signalformungseinrichtung (22), die einen solchen Frequenzgang (32) aufweist, daß der Gesamtfrequenzgang (34) der Signalformungseinrichtung (22) und des Bandpaßfilters (14) dem Frequenzgang eines Filters entspricht, dessen Durchlaßbandbreite zumindest gleich der vorbestimmten Bandbreite ist.

2. Vorrichtung nach Anspruch 1, bei der die vorbestimmte Bandbreite der dreifachen Signalbandbreite des zu übertragenden Signals (S1) entspricht.

3. Vorrichtung nach Anspruch 1 oder 2, bei der die Linearisierungseinrichtung (20) und die Signalformungseinrichtung (22) in der Bodenstation (10) eines Satellitenübertragungssystem angeordnet sind, und bei der das Bandpaßfilter (14) und der nichtlineare Verstärker (16) in einem Satelliten (12) des Satellitenübertragungssystems angeordnet sind.

4. Vorrichtung nach einem der Ansprüche 1 bis 3, die ferner einen Empfänger (24) zum Empfangen eines über den Übertragungsweg übertragenen Signals (S5) und eine Einrichtung (26) zum Einstellen von Koeffizienten der Linearisierungseinrichtung (20) und/oder der Signalformungseinrichtung (22) basierend auf dem empfangenen übertragenen Signal (S5) und dem zu übertragenden Signal (S1) aufweist.

5. Verfahren zum Übertragen eines ersten Signals (S1) über einen Übertragungsweg, der ein Bandpaßfilter (14), dessen Durchlaßbandbreite kleiner als eine vorbestimmte Bandbreite ist, und einen nichtlinearen Verstärker (16) aufweist, mit folgenden Schritten:
Durchführen einer solchen Linearisierung des ersten Signals (S1), das eine durch den nichtlinearen Verstärker (16) bewirkte Nichtlinearität kompensiert wird, zum Erzeugen eines zweiten Signals (S2);
Leiten des zweiten Signals (S2) durch eine Signalformungseinrichtung (22), die einen solchen Frequenzgang (32) aufweist, daß die Gesamtfrequenzgang (34) der Signalformungseinrichtung (22) und des Bandpaßfilters (14) dem Frequenzgang eines Filters entspricht, dessen Durchlaßbandbreite zumindest gleich der vorbestimmten Bandbreite ist, zum Erzeugen eines dritten Signals (S3);
Übertragen des dritten Signals (S3) über den Übertragungsweg.

## Claims

1. Device for pretreating a signal (S1) to be transmitted over a transmission path, wherein the transmission path comprises a band-pass filter (14) whose pass-band width (30) is smaller than a predetermined bandwidth and a non-linear amplifier (16), comprising:
linearization means (20) for performing such a linearization of the signal (S1) to be transmitted before the transmission of the same, that a non-linearity caused by the non-linear amplifier (16) is counteracted;
signal-shaping means (22) downstream to the linearization means (20) comprising such a frequency response (32) that the overall frequency response (34) of the signal-shaping means (22) and the band-pass filter (14) corresponds to the frequency response of a filter whose pass-band width is at least equal to the predetermined bandwidth.

2. Device according to claim 1, wherein the predetermined bandwidth corresponds to three times the signal bandwidth of the signal (S1) to be transmitted.

3. Device according to claim 1 or 2, wherein the linearization means (20) and the signal-shaping means (22) are arranged in the ground station (10) of a satellite transmission system and wherein the band-pass filter (14) and the non-linear amplifier (16) are arranged in a satellite (12) of the satellite transmission system.

4. Device according to one of claims 1 to 3, further comprising a receiver (24) for receiving a signal (S5) to be transmitted over the transmission path and a means (26) for setting coefficients of the linearization means (20) and/or the signal-shaping means (22) based on the received transmitted signal (S5) and the signal (S1) to be transmitted.

5. Method for transmitting a first signal (S1) over a transmission path comprising a band-pass filter (14) whose pass-band width is less than a predetermined bandwidth, and a non-linear amplifier (16), comprising the following steps:
performing such a linearization of the first signal (S1) that a non-linearity caused by the non-linear amplifier (16) is compensated for, in order to generate a second signal (S2);
directing the second signal (S2) through a signal-shaping means (22) comprising such a frequency response (32) that the overall frequency response (34) of the signal-shaping means (22) and the band-pass filter (14) corresponds to the frequency response of a filter whose pass-band width is at least equal to the predetermined bandwidth, in order to generate a third signal (S3) ;
transmitting the third signal (S3) over the transmission path.

## Revendications

1. Dispositif de prétraitement d'un signal à transmettre sur un trajet de transmission (S1), le trajet de transmission présentant un filtre passe-bande (14) dont la largeur de bande passante (30) est inférieure à une largeur de bande prédéterminée, et un amplificateur non-linéaire (16), aux caractéristiques suivantes :
un dispositif de linéarisation (20) destiné à effectuer une linéairisation du signal à transmettre (S1) avant la transmission de ce dernier de sorte que soit contrecarrée une non-linéarité provoquée par l'amplificateur non linéaire (16) ;
un dispositif de formation de signal (22), connecté après le dispositif de linéarisation (20), présentant une réponse en fréquence (32) telle que la réponse en fréquence totale (34) du dispositif de formation de signal (22) et du filtre passe-bande (14) corresponde à la réponse en fréquence d'un filtre dont la largeur de bande passante est au moins égale à la largeur de bande prédéterminée.

2. Dispositif selon la revendication 1, dans lequel la largeur de bande prédéterminée correspond à trois fois la largeur de bande du signal à transmettre (S1).

3. Dispositif selon la revendication 1 ou 2, dans lequel le dispositif de linéarisation (20) et le dispositif de formation de signal (22) est disposé dans la station au sol (10) d'un système de transmission par satellite, et dans lequel le filtre passe-bande (14) et l'amplificateur non-linéaire (16) sont disposés dans un satellite (12) du système de transmission par satellite.

4. Dispositif selon l'une des revendications 1 à 3, présentant, par ailleurs, un récepteur (24) destiné à recevoir un signal (55) à transmettre sur un trajet de transmission et un dispositif (26) destiné à régler des coefficients du dispositif de linéarisation (20) et/ou du dispositif de formation de signal (22) sur base du signal transmis reçu (S5) et du signal à transmettre (S1).

5. Procédé de transmission d'un premier signal (S1) sur un trajet de transmission, présentant un filtre passe-bande (14) dont la largeur de bande passante est inférieure à une largeur de bande prédéterminée, et un amplificateur non-linéaire (16), aux étapes suivantes consistant à:
effectuer une linéarisation du premier signal (S1) telle que soit compensée une non-linéarité provoquée par l'amplificateur non-linéaire (16), pour générer un deuxième signal (S2) ;
conduire le deuxième signal (S2) à travers un dispositif de formation de signal (22) présentant une réponse en fréquence (32) telle que la réponse en fréquence totale (34) du dispositif de formation de signal (22) et du filtre passe-bande (14) corresponde à la réponse en fréquence d'un filtre dont la largeur de bande passante est au moins égale à la largeur de bande prédéterminée, pour générer un troisième signal (S3) ;
transmettre le troisième signal (S3) sur le trajet de transmission.
